(19) Europäisches Patentamt / European Patent Office / Office européen des brevets

(11) **EP 4 760 338 A1**

(12) **DEMANDE DE BREVET EUROPEEN**

(43) Date de publication:
**17.06.2026 Bulletin 2026/25**

(21) Numéro de dépôt: **25222101.5**

(22) Date de dépôt: **10.12.2025**

(51) Classification Internationale des Brevets (IPC):
**G01S 7/481** (2006.01)    **G01S 17/894** (2020.01)
**H04N 25/705** (2023.01)    **H04N 25/771** (2023.01)

(52) Classification Coopérative des Brevets (CPC):
**G01S 17/894; G01S 7/4816; H04N 25/705; H04N 25/77; H04N 25/771**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **13.12.2024 FR 2414062**

(71) Demandeur: **Commissariat à l'Energie Atomique et aux Energies Alternatives**
**75015 Paris (FR)**

(72) Inventeurs:
• **PALMIGIANI, Gaëlle**
 **38054 GRENOBLE CEDEX 09 (FR)**
• **SAXOD, Olivier**
 **38054 GRENOBLE CEDEX 09 (FR)**

(74) Mandataire: **Santarelli**
**Tour Trinity**
**1 bis Place de la Défense**
**92400 Courbevoie (FR)**

(54) **CAPTEUR D'UNE IMAGE EN PROFONDEUR PRÉSENTANT UNE ARCHITECTURE EN CHARGES**

(57) L'invention porte sur un capteur d'une image comprenant au moins un pixel de profondeur comportant deux zones de stockage commandables. Chacune comporte une région mémoire séparée d'une région photosensible par une barrière de potentiel électrique ; une grille de transfert s'étendant en vis-à-vis de la barrière ; une grille de transfert inverse s'étendant en vis-à-vis de la barrière et d'une partie supérieure de la région photosensible. Une voie d'écoulement de charges s'étendant entre les grilles de transfert, à l'aplomb de la région photosensible, comporte une zone de collecte séparée de la région photosensible par un canal. Un circuit est configuré pour : échantillonner un signal dans chaque mémoire ; et pour chaque zone de stockage, vider la mémoire par activation des grilles de transfert et de la grille de transfert inverse de la zone de stockage entre une initialisation et une lecture d'un nœud de lecture.

[Fig. 2A]

**Fig. 2A**

EP 4 760 338 A1

## Description

## DOMAINE TECHNIQUE

Le domaine de l'invention est celui des capteurs d'image en profondeur fonctionnant sur un principe de mesure indirecte de temps de vol.

## ÉTAT DE LA TECHNIQUE ANTÉRIEURE

Les capteurs d'image en profondeur peuvent permettre d'obtenir une image en relief d'une scène. Parmi ceux-ci, il existe les capteurs d'image en profondeur fonctionnant sur un principe de mesure indirecte de temps de vol, appelés généralement « capteurs d'image iToF » (iToF pour « Indirect Time of Flight », en anglais). Un tel capteur d'image en profondeur comprend généralement une matrice de pixels de profondeur. Il est associé à une source lumineuse, par exemple un laser, pour éclairer la scène. La source lumineuse émet un signal lumineux périodique en amplitude, souvent sinusoïdal. Un pixel, ou un groupe de pixels contigus correspondant à un point de l'image, échantillonne le signal périodique reçu après réflexion sur la scène. Le capteur comprend des moyens de traitement permettant de déterminer un déphasage entre les signaux périodiques émis et reçus, et de convertir le déphasage en une distance séparant le capteur d'image du point de la scène conjugué avec le point de l'image.

Il est communément admis qu'au moins trois échantillons sur une période du signal périodique sont nécessaires pour effectuer une mesure de distance. Il est préférable d'utiliser au moins quatre échantillons. Un échantillon est une intégration du signal périodique reçu par un pixel pendant un ou plusieurs intervalles temporels, chacun égal à une fraction de la période du signal périodique, les intervalles temporels étant espacés d'une période du signal périodique. De préférence, la fraction de la période du signal périodique est la même pour tous les échantillons, par exemple égale à l'inverse du nombre d'échantillons. Généralement, les intervalles temporels d'intégration d'échantillons distincts ne se recouvrent pas.

Un pixel de profondeur comprend typiquement une région photosensible configurée pour convertir les photons du signal lumineux reçu en charges électriques, ainsi qu'un transistor de transfert et un nœud de lecture par branche d'échantillonnage ou pour plusieurs branches d'échantillonnage. Le transistor de transfert permet de transférer les charges électriques depuis la région photosensible vers le nœud de lecture pendant les intervalles temporels correspondant à un échantillon.

Parmi les pixels de profondeur fonctionnant sur un principe de mesure indirecte de temps de vol, on distingue deux familles, à savoir les architectures en charges et les architectures en tension.

Dans un pixel de profondeur selon une architecture en tension, le nœud de lecture est directement connecté à une source ou un drain du transistor de transfert. Le transistor de transfert bascule à l'état passant au cours des intervalles temporels d'intégration d'un échantillon. Ainsi, des charges photo-générées s'accumulent sur le nœud de lecture au cours d'une phase d'échantillonnage, faisant varier un potentiel d'échantillonnage du nœud de lecture. Le potentiel d'échantillonnage est ensuite lu en fin de phase d'échantillonnage. Le nœud de lecture doit être réinitialisé entre chaque prise d'échantillon. Il peut être réinitialisé à un potentiel d'initialisation en début de phase d'échantillonnage et/ou après la lecture du potentiel d'échantillonnage. La lecture du potentiel d'échantillonnage est comparée à une lecture du potentiel d'initialisation sur le nœud de lecture pour déterminer la valeur de l'échantillon. Cependant la réinitialisation du nœud de lecture ajoute un bruit thermique au potentiel d'initialisation, communément appelé bruit kTC, qui se répercute sur la valeur de l'échantillon dans ce type d'architecture.

Une architecture en charges permet de mettre en œuvre une technique de réduction du bruit kTC connue sous le nom de double échantillonnage corrélé (ou CDS, pour « Correlated Double Sampling » en anglais). Un pixel de profondeur selon une architecture en charges comporte une mémoire et un deuxième transistor de transfert pour chaque branche d'échantillonnage, agencés entre le transistor de transfert et le nœud de lecture. La mémoire est par conséquent dissociée du nœud de lecture par le canal du deuxième transistor de transfert. Un exemple de pixel de profondeur présentant une architecture en charges est donné dans le document US 2019/0086519.

Les charges photo-générées s'accumulent dans la mémoire au cours des intervalles temporels d'intégration d'un échantillon. A la fin de la phase d'échantillonnage, le nœud de lecture est réinitialisé à un potentiel d'initialisation qui est lu avant un transfert des charges électriques stockées dans la mémoire vers le nœud de lecture par activation du deuxième transistor de transfert. Une lecture du potentiel du nœud de lecture après transfert est soustraite à la valeur lue du potentiel d'initialisation pour obtenir la valeur de l'échantillon. Les deux lectures se faisant immédiatement l'une après l'autre, sans commutation d'un interrupteur, les bruits kTC sont corrélés et sont donc éliminés lors de la soustraction.

Pour une architecture en charges, chaque mémoire est cependant encombrante et occupe souvent une zone aveugle du pixel de profondeur. Or, il n'est pas souhaitable d'en réduire son empreinte au risque de compromettre une dynamique de détection des échantillons, c'est-à-dire la différence maximale entre deux valeurs d'échantillons que le pixel de profondeur ou le capteur d'image peut enregistrer simultanément. Cette contrainte est d'autant plus exacerbée que la taille du pixel de profondeur est réduite pour augmenter une résolution du capteur, ou que la région photosensible est grande pour augmenter sa sensibilité.

Il existe des capteurs d'image particuliers, souvent appelés capteurs RGBZ, permettant d'obtenir une image en intensité d'une scène contenant une information de distance entre le capteur et la scène. De tels capteurs comportent généralement une pluralité de blocs de pixels, chaque bloc de pixels comprenant un groupe image d'au moins un pixel d'intensité et un macro-pixel Z comprenant au moins un pixel de profondeur. Le groupe image est configuré pour fournir une information d'intensité d'une scène observée. Le macro-pixel Z est configuré pour donner une information de distance séparant la scène du capteur. Dans un capteur RGBZ, le groupe image consiste généralement en trois pixels d'intensité, un pixel sensible dans le rouge, un dans le vert et un dans le bleu. L'ensemble des pixels est agencé en matrice. Il est par conséquent préférable que les pixels de profondeur aient sensiblement la même taille que les pixels d'intensité. Il est donc souhaitable que la taille des pixels de profondeur suive la même tendance de réduction que les pixels d'intensité. Ceci rend souvent difficile, voire impossible l'adoption d'une architecture en charges.

Il existe donc un besoin pour un pixel de profondeur plus compact et/ou une nouvelle architecture de pixel de profondeur permettant un double échantillonnage corrélé, sans compromission sur la taille du pixel de profondeur, la résolution ou la sensibilité du capteur d'image.

## EXPOSÉ DE L'INVENTION

L'invention a pour objectif de remédier au moins en partie aux inconvénients de l'art antérieur, et plus particulièrement de proposer un capteur d'image comportant une pluralité de pixels dont au moins un est un pixel de profondeur permettant de collecter plusieurs échantillons, plus compact que les pixels de profondeur de l'art antérieur.

Pour cela, l'objet de l'invention est un capteur d'une image comprenant un circuit de lecture et une pluralité de pixels formés dans et/ou sur un substrat du capteur, tel qu'au moins un parmi les pixels est un pixel de profondeur, chaque pixel de profondeur comportant une région photosensible du substrat, une première et une deuxième zones de stockage commandables.

Chaque zone de stockage commandable comprend : une voie d'écoulement de charges électriques s'étendant verticalement dans le substrat à l'aplomb de la région photosensible et comportant un puits de potentiel nommé région mémoire et une barrière de potentiel électrique nommée barrière intercalée entre la région mémoire et la région photosensible ; une grille de transfert s'étendant verticalement dans le substrat à l'aplomb de la région photosensible, en vis-à-vis de la barrière ; une grille de transfert inverse s'étendant verticalement dans le substrat en vis-à-vis de la barrière et d'une partie supérieure de la région photosensible.

Chaque pixel de profondeur comporte une voie additionnelle d'écoulement de charges électriques s'étendant verticalement dans le substrat entre les grilles de transfert respectives des première et deuxième zones de stockage commandables, à l'aplomb de la région photosensible, comportant un puits de potentiel électrique nommé zone de collecte et une barrière de potentiel électrique, nommée canal de collecte, intercalée entre la zone de collecte et la région photosensible.

Le circuit de lecture comporte un nœud de lecture connecté électriquement à la zone de collecte et est configuré pour successivement : appliquer, dans chaque zone de stockage commandable, un train d'impulsions périodique à la grille de transfert au cours d'une phase d'échantillonnage commune à la première et à la deuxième zones de stockage commandables, de sorte à écouler des charges électriques depuis la région photosensible vers la région mémoire au cours des impulsions, les trains d'impulsions respectifs des première et deuxième zones de stockage commandables étant déphasés l'un par rapport à l'autre, et de même période ; procéder à une première initialisation du nœud de lecture ; procéder à une première évacuation de charges au cours de laquelle les grilles de transfert des première et deuxième zones de stockage commandables, et la grille de transfert inverse de la première zone de stockage commandable sont activées de sorte à écouler les charges électriques depuis la région mémoire de la première zone de stockage commandables vers la zone de collecte ; lire un potentiel électrique Vsig1 du nœud de lecture ; procéder à une deuxième initialisation du nœud de lecture ; procéder à une deuxième évacuation de charges au cours de laquelle les grilles de transfert des première et deuxième zones de stockage commandables, et la grille de transfert inverse de la deuxième zone de stockage commandable sont activées de sorte à écouler les charges électriques depuis la région mémoire de la deuxième zone de stockage commandables vers la zone de collecte ; lire un potentiel électrique Vsig2 du nœud de lecture.

**Certains** aspects préférés mais non limitatifs de ce capteur sont les suivants.

Le circuit de lecture peut être configuré pour lire un potentiel électrique Vinit1 du nœud de lecture entre la première initialisation et la première évacuation, et un potentiel électrique Vinit2 du nœud de lecture entre la deuxième initialisation et la deuxième évacuation. Le capteur peut comprendre des moyens pour opérer un premier double échantillonnage corrélé à partir de Vinit1 et Vsig1, et un deuxième double échantillonnage corrélé à partir de Vinit2 et Vsig2.

Chaque zone de stockage commandable peut comporter une grille de pincement. Dans chaque zone de stockage commandable, la voie d'écoulement peut comporter une zone de pincement pouvant recouvrir la région mémoire d'un côté de la région mémoire opposé à la barrière, la grille de pincement peut s'étendre verticalement dans le substrat en vis-à-vis de la région mémoire, et le circuit de lecture peut être configuré pour appliquer une différence de potentiel électrique entre la zone de pincement et la grille de pincement de sorte à passiver la région mémoire à partir de charges électriques issues de la zone de pincement.

Dans chaque zone de stockage commandable, la grille de pincement peut être logée dans une encoche pratiquée dans la grille de transfert inverse.

La zone de collecte peut s'étendre verticalement dans le substrat, plus profondément que les régions mémoires des première et deuxième zones de stockage commandables.

Pour chaque pixel de profondeur, le canal de collecte, la zone de collecte, la barrière et la région mémoire de chaque zone de stockage commandable peuvent être dopés d'un premier type de conductivité, et chaque région mémoire peut avoir une concentration en éléments dopants strictement inférieure à une concentration en éléments dopants de la zone de collecte.

Pour chaque pixel de profondeur, chaque zone de pincement peut être dopée d'un deuxième type de conductivité opposé au premier type de conductivité.

Le canal de collecte et la barrière de chaque zone de stockage commandable peuvent avoir des concentrations en éléments dopants identiques.

Pour chaque pixel de profondeur, la grille de transfert de chaque zone de stockage commandable peut avoir une forme en U en vue de dessus, pouvant entourer la voie d'écoulement.

Le circuit de lecture peut comporter un contact électrique d'initialisation par pixel de profondeur. Chaque pixel de profondeur peut comporter une zone de contact périphérique du premier type de conductivité d'un seul tenant avec la zone de collecte, agencée en périphérie du pixel de profondeur, sur laquelle repose le contact électrique d'initialisation.

Pour chaque pixel de profondeur et chaque zone de stockage commandable, la grille de pincement peut occuper une encoche pratiquée dans la grille de transfert inverse.

La pluralité de pixels peut être agencée en matrice et dans lequel les grilles de pincement et les grilles de transfert inverse peuvent être agencées dans des plans de séparation entre deux pixels de la matrice de pixels.

Tous les pixels de la matrice peuvent avoir la même taille. La matrice de pixels peut comporter des pixels d'intensité configurés pour délivrer un signal représentatif d'une intensité d'un flux lumineux incident.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

la figure 1A est une vue schématique de dessus d'un exemple de pixel de profondeur selon l'invention ;

la figure 1B est une vue schématique selon la coupe A-A de la figure 1A de l'exemple de pixel de profondeur ;

la figure 2A est un schéma électrique d'un circuit de lecture adapté au pixel de profondeur des figures 1A et 1B ;

la figure 2B est un chronogramme illustrant un fonctionnement possible du circuit de lecture ;

la figure 3 est une vue schématique de dessus d'une variante du pixel de profondeur des figures 1A et 1B ;

la figure 4 est une vue schématique partielle, de dessus, d'une matrice de pixels de profondeur ;

la figure 5 est une vue schématique partielle, de dessus, d'une matrice de pixels mixant des pixels d'intensité et des pixels de profondeur ;

la figure 6 est une vue schématique selon la coupe A-A de la figure 4 ou de la figure 5.

## EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un capteur d'une image. Le capteur comprend un substrat, un circuit de lecture et une pluralité de pixels formés dans et/ou sur le substrat. Au moins un pixel parmi la pluralité de pixels est un pixel de profondeur.

Chaque pixel de profondeur comporte une région photosensible. Il comprend en outre une première et une deuxième zones de stockage commandables agencées à l'aplomb de la région photosensible. Chaque zone de stockage commandable comporte une voie d'écoulement de charges électriques, une grille de transfert, une grille de transfert inverse et une grille de pincement optionnelle. La voie d'écoulement comprend une région mémoire séparée de la région photosensible par une barrière.

Chaque pixel de profondeur comporte en outre une voie additionnelle d'écoulement de charges électriques, également agencée à l'aplomb de la région photosensible, comportant une zone de collecte séparée de la région photosensible par une barrière de potentiel électrique nommée canal de collecte. Un nœud de lecture du circuit de lecture est connecté électriquement à la zone de collecte.

Pour chaque zone de stockage commandable, les grilles s'étendent verticalement dans le substrat. La grille de transfert est à l'aplomb de la région photosensible. La grille de transfert et la grille de transfert inverse s'étendent en vis-à-vis de la barrière, de sorte que cette dernière est commandable indifféremment par la grille de transfert ou par la grille de transfert inverse, ou par les deux simultanément. La grille de transfert inverse s'étend en outre en vis-à-vis d'une partie supérieure de la région photosensible, de façon à pouvoir faire changer de signe une différence de potentiels électriques entre la région mémoire et la région photosensible.

Cet agencement en combinaison avec une configuration particulière du circuit de lecture permet de commander chaque zone de stockage de façon à permettre un écoulement à double sens des charges électriques dans la voie d'écoulement. Il est ainsi possible d'accumuler des charges électriques photo-générées dans la région mémoire au cours d'une phase d'échantillonnage et de les évacuer au cours d'une phase de lecture vers la zone de collecte. Un potentiel électrique du nœud de lecture est ensuite lu par le circuit de lecture. Celui-ci correspond au nombre de charges accumulées, puis transférées. La région mémoire ainsi vidée peut servir de réceptacle pour une nouvelle phase d'échantillonnage.

En fonctionnement, la région photosensible est destinée à recevoir un rayonnement électromagnétique incident sur une face inférieure du substrat opposée à la zone de stockage commandable. Ainsi, le pixel de profondeur est compact et ne présente pas ou peu de zones aveugles.

La voie additionnelle d'écoulement de charges électriques s'étend verticalement entre les grilles de transfert. Les grilles de transfert sont agencées de sorte à pouvoir commander le canal de collecte. Une activation simultanée des grilles de transfert rend prioritaire le transfert des charges électriques depuis la région photosensible vers la zone de collecte, par rapport à un transfert vers une région mémoire d'une zone de stockage commandable. Il est ainsi possible d'initialiser la région photosensible ou, éventuellement, d'évacuer des charges photo-générées ne devant pas être collectées lors de la phase d'échantillonnage, sans grilles et/ou interconnexions supplémentaires. Cela permet d'accroître la compacité du pixel de profondeur.

Dans la description, un transfert de charges électriques depuis une première région selon un canal, ou vers une deuxième région, est dit prioritaire, si au moins 90 % des charges électriques transférées depuis la première région le sont par ce canal, ou atteignent la deuxième région. Le cas échéant, la proportion est préférentiellement supérieure ou égale à 95 %, voire supérieur ou égal à 97 %, ou encore supérieur ou égal à 99 %.

Des modes de réalisation particuliers vont être décrits se rapportant à un capteur d'une image comportant un circuit de lecture à base de transistors NMOS. Cependant, ces modes de réalisation peuvent être adaptés à d'autres types de circuit de lecture permettant de mettre en œuvre l'enseignement technique de la description sans sortir du cadre de l'invention. Il est par exemple possible d'utiliser un circuit de lecture à base de transistors PMOS ou une combinaison de transistors NMOS et PMOS.

Similairement, chaque mode de réalisation décrit ci-après adopte une combinaison particulière de conductivités associées aux zones dopées, étant entendu que la combinaison peut être inversée sans sortir du cadre de l'invention. Ainsi, pour un mode de réalisation particulier toutes les zones dopées P peuvent être dopées N et toutes les zones dopées N peuvent être dopées P, à condition de changer le type de conductivité de toutes les zones dopées. Les exemples de potentiels électriques ou tensions de polarisation données dans la description sont données relativement à la combinaison particulière de conductivités et de concentrations de dopage prise pour les exemples de réalisation, en association avec un exemple de circuit de lecture NMOS. Il est à la portée de la personne du métier d'établir les potentiels électriques et/ou les tensions de polarisation convenant à d'autres combinaisons possibles dans le cadre de l'invention.

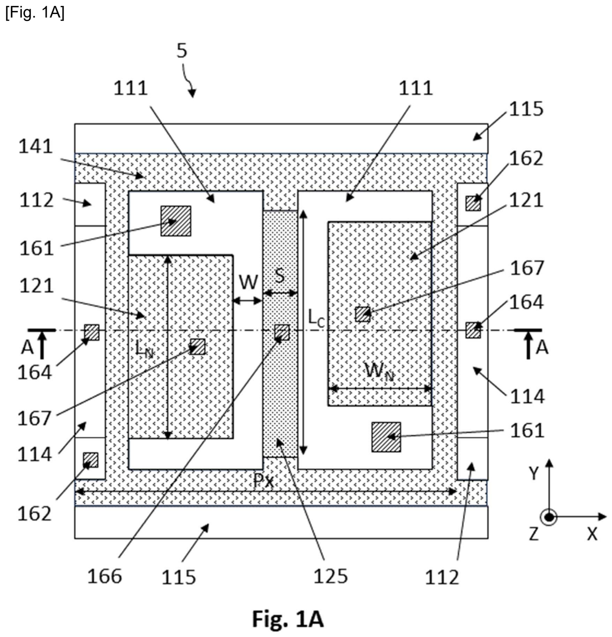

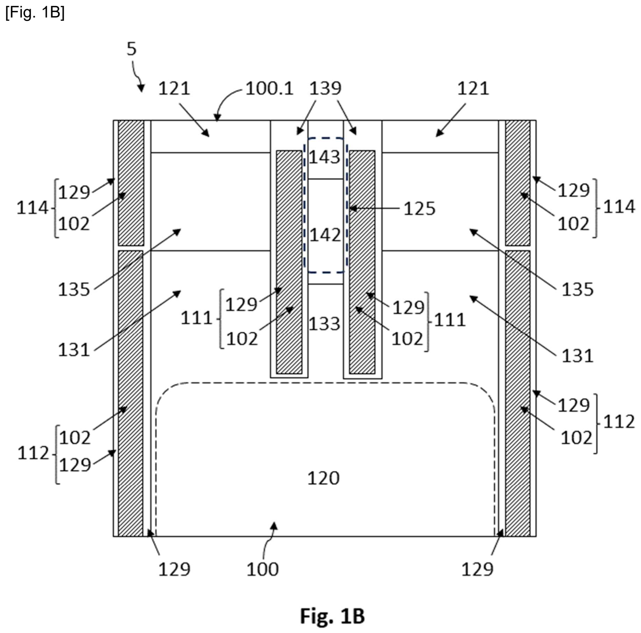

Un exemple de pixel de profondeur 5 d'un capteur d'une image selon l'invention va à présent être décrit en lien avec les figures 1A et 1B. Les figures 1A et 1B sont des vues schématiques respectivement, de dessus et en coupe. Le plan de coupe de la figure 1B est représenté par une ligne mixte sur la figure 1A.

Le capteur d'une image comprend un circuit de lecture et une pluralité de pixels formés dans et sur un substrat 100, dont au moins un est un pixel de profondeur 5. Sur les figures 1A à 1B, seul un pixel de profondeur 5 a été représenté. Pour ne pas surcharger les schémas, certains éléments ont été omis, comme par exemple des lignes d'interconnexion ou certains contacts électriques. Pour en améliorer la lisibilité, seule une partie supérieure du substrat 100 est représentée sur la vue en coupe. Sur les vues schématiques, les éléments sont représentés par des formes géométriques simples. Ceux-ci sont reproduits sur le dispositif réalisé à des erreurs de fabrication près, comme par exemple des erreurs d'alignement, de dimensionnel ou des arrondis de coins induits par un manque de résolution.

Le substrat 100 comporte une face supérieure 100.1 et une face inférieure opposée à la face supérieure 100.1. Les faces inférieure et supérieure 100.1 sont sensiblement planes et parallèles entre elles. Le pixel de profondeur 5 comprend une région photosensible 120, une première et une deuxième zones de stockage commandables. Chaque zone de stockage commandable comporte une voie d'écoulement. La voie d'écoulement comprend une barrière 131, une région mémoire 135 et une zone de pincement 121.

Les zones de stockage commandables sont de préférence similaires ou identiques. Elles peuvent par exemple être obtenues, l'une à partir d'une autre, par une isométrie de l'espace, comme par exemple une symétrie orthogonale par rapport à un plan, ou par rapport à un axe. Dans cet exemple, la deuxième zone de stockage commandable se déduit de la première zone de stockage commandable par une symétrie axiale par rapport à un axe perpendiculaire à la face supérieure 100.1, passant par le centre du pixel de profondeur 5. Ainsi, seule la première zone de stockage commandable est décrite explicitement ci-après.

Le pixel de profondeur 5 comporte une voie d'écoulement additionnelle. La voie d'écoulement additionnelle comprend une zone de collecte 125 et un canal de collecte 133. Dans cet exemple, la zone de pincement 121 de chaque zone de stockage commandable et la zone de collecte 125 affleurent la face supérieure 100.1. La voie d'écoulement de chaque zone de stockage commandable et la voie d'écoulement additionnelle s'étendent verticalement dans le substrat 100 à l'aplomb de la région photosensible 120, entre la région photosensible 120 et la face supérieure 100.1 du substrat 100.

On définit ici et pour la suite de la description un repère direct tridimensionnel orthogonal (X, Y, Z), où les axes X et Y forment un plan parallèle à la face supérieure 100.1 du substrat 100, l'axe X étant orienté dans le plan de coupe A-A de la figure 1A, et où l'axe Z est orienté de manière sensiblement orthogonale à la face supérieure 100.1, depuis la région photosensible 120 vers la face supérieure 100.1. Dans la suite de la description, les termes « vertical » et « verticalement » s'entendent comme étant relatifs à une orientation sensiblement parallèle à l'axe Z, et les termes « horizontal » et « horizontalement » comme étant relatifs à une orientation sensiblement parallèle au plan (X, Y). Par ailleurs, les termes « inférieur » et « supérieur » s'entendent comme étant relatifs à un positionnement croissant lorsqu'on s'éloigne de la face supérieure 100.1 du substrat 100, suivant la direction +Z. Le terme « latéral » se réfère à une orientation sensiblement parallèle à l'axe Z.

Le substrat 100 est en un matériau semiconducteur. Il est ici en silicium cristallin. Il s'agit par exemple d'une plaque en silicium ou d'une partie d'une plaque en silicium. Il peut comprendre une ou plusieurs couches épitaxiées en silicium cristallin, ainsi qu'une ou plusieurs couches de passivation.

La barrière 131 est agencée entre la région photosensible 120 et la région mémoire 135. La barrière 131 constitue une barrière de potentiel électrique pour des charges électriques destinées à être photo-générées dans la région photosensible 120. Les charges électriques photo-générées sont ici des électrons d'une bande de conduction de la région photosensible 120. La région mémoire 135 constitue un puits de potentiel électrique pour les charges électriques photo-générées.

La zone de pincement 121 recouvre la région mémoire 135, d'un côté de la région mémoire 135 opposé à la barrière 131. La zone de pincement 121 recouvre de préférence entièrement la région mémoire 135. La zone de stockage commandable comporte en outre une grille de pincement 114. La grille de pincement 114 s'étend verticalement dans le substrat 100 en vis-à-vis de la région mémoire 135. La zone de pincement 121 et/ou la grille de pincement 114 sont destinées à fixer un potentiel électrique, dit de pincement, de la région mémoire 135. De préférence, la zone de pincement 121 et/ou la grille de pincement 114 sont destinées à dépléter la région mémoire 135 en absence de charges électriques photo-générées.

Chaque zone de stockage commandable comporte en outre une grille de transfert 111 et une grille de transfert inverse 112. La grille de transfert 111 s'étend verticalement dans le substrat 100 à l'aplomb de la région photosensible 120 entre la face supérieure 100.1 et la région photosensible 120. Elle s'étend en vis-à-vis de la barrière 131. De préférence, comme cela est le cas ici, elle s'étend verticalement en vis-à-vis de la région mémoire 135.

La grille de transfert inverse 112 s'étend verticalement dans le substrat 100 en vis-à-vis de la barrière 131 et d'une partie supérieure de la région photosensible 120, de préférence en vis-à-vis de toute la région photosensible 120. Avantageusement, la grille de transfert inverse 112 s'étend sensiblement jusqu'à la face inférieure du substrat 100. Elle délimite ici une face latérale de la région photosensible 120. Elle s'étend selon un plan parallèle au plan (Y, Z). Dans un plan parallèle à la face supérieure 100.1 et suivant une direction parallèle à l'axe X, la distance Px séparant un bord externe de la grille de transfert inverse 112 de la première zone de stockage commandable à un bord interne de la grille de transfert inverse 112 de la deuxième zone de stockage commandable définit une taille du pixel de profondeur 5. Dans cet exemple, la taille Px du pixel est égale à 1,2 $\mu m$. Elle peut être inférieure ou égale à 1,2 $\mu m$, voire inférieure ou égale à 1 $\mu m$. La région photosensible 120 s'étend dans une direction parallèle à X, d'une grille de transfert inverse 112 d'une zone de stockage commandable à la grille de transfert inverse 112 de l'autre zone de stockage commandable.

Une ou des distances horizontales séparant la grille de transfert 111 de la grille de transfert inverse 112 au niveau de la barrière 131 et une concentration en éléments dopants de la barrière 131 sont de nature à réaliser une barrière de potentiel électrique au niveau de la barrière 131, entre la région photosensible 120 et la région mémoire 135. Similairement, une ou des distances horizontales séparant la grille de transfert 111 de la grille de pincement 114 et une concentration en éléments dopants de la région mémoire 135 sont de nature à réaliser un puits de potentiel électrique au niveau de la région mémoire 135, entre la barrière 131 et la zone de pincement 121. La grille de transfert 111 et la grille de transfert inverse 112 sont en regard l'une de l'autre au niveau de la barrière 131 de sorte que celle-ci est commandable indifféremment par l'une ou l'autre de la grille de transfert 111 ou de la grille de transfert inverse 112, ou simultanément par les deux.

Dans cet exemple, la région photosensible 120, la barrière 131 et la région mémoire 135 sont dopées d'un premier type de conductivité. Ici, le premier type de conductivité est de type n. La barrière 131 et la région mémoire 135 ont des concentrations en éléments dopants respectivement égales à N1 et N2, telles que N1 est strictement inférieure à N2.

La barrière 131 s'étend horizontalement de la grille de transfert 111 jusqu'à la grille de transfert inverse 112. La région mémoire 135 s'étend horizontalement de la grille de transfert 111 jusqu'à la grille de pincement 114. Ici, la grille de pincement 114 occupe une encoche pratiquée dans la grille de transfert inverse 112. Elle est sensiblement plane et parallèle au plan (Y, Z).

La voie d'écoulement additionnel s'étend verticalement dans le substrat 100, entre les grilles de transfert 111 respectives des première et deuxième zones de stockage commandables, et à l'aplomb de la région photosensible 120. Le canal de collecte 133 est agencé entre la région photosensible 120 et la zone de collecte 125. Le canal de collecte 133 constitue une barrière de potentiel électrique pour les charges électriques destinées à être photo-générées dans la région photosensible 120. La zone de collecte 125 constitue un puits de potentiel électrique pour les charges électriques photo-générées.

Dans cet exemple, le canal de collecte 133 et la zone de collecte 125 sont dopés du premier type de conductivité. Le canal de collecte 133 peut avoir une concentration en éléments dopants égales à la barrière 131, comme cela est le cas dans cet exemple. Le cas échéant, les dopages du canal de collecte 133 et de la barrière 131 peuvent résulter d'un dopage in-situ lors d'une croissance par épitaxie. La croissance par épitaxie peut inclure la formation de la région photosensible 120.

Le canal de collecte 133 s'étend horizontalement depuis la grille de transfert 111 de la première zone de stockage commandable jusqu'à la grille de transfert 111 de la deuxième zone de stockage commandable.

Toutes les grilles de la première zone de stockage commandable parmi un ensemble de grilles consistant en la grille de transfert 111, la grille de transfert inverse 112, et la grille de pincement 114, peuvent chacune affleurer la face supérieure 100.1 du substrat 100, sans que cela soit indispensable. Chaque grille de l'ensemble de grilles comporte une électrode 102 en un matériau conducteur de l'électricité, comme un métal ou un semiconducteur dopé. Les électrodes 102 sont avantageusement en un même matériau. Elles sont ici toutes en silicium polycristallin dopé. Elles sont dopées d'un deuxième type de conductivité opposé au premier type de conductivité, c'est-à-dire dopées p dans cet exemple.

La région photosensible 120 peut être dopée ou intrinsèque. Une géométrie de la grille de transfert inverse 112 et une concentration en éléments dopants de la région photosensible 120 sont telles que la région mémoire 135 de chaque zone de stockage commandable a un potentiel électrique intermédiaire entre un potentiel électrique de la région photosensible 120 et un potentiel électrique de la zone de collecte 125, lorsque toutes les grilles de l'ensemble de grilles sont au même potentiel électrique. Le potentiel électrique de la région photosensible 120 peut être égal au potentiel électrique de la région mémoire 135.

L'électrode 102 de chaque grille de l'ensemble de grilles est revêtue d'un revêtement diélectrique 129 de la grille. Les revêtements diélectriques 129 sont en tout matériau diélectrique. Ils sont ici en oxyde de silicium. Chaque grille est isolée électriquement du substrat 100 semiconducteur par un revêtement diélectrique 129. Un revêtement diélectrique 129 isole électriquement l'électrode 102 de la grille de pincement 114 de l'électrode 102 de la grille de transfert inverse 112.

La grille de transfert 111 comporte une région isolante 139 recouvrant l'électrodes 102 et affleurant la face supérieure 100.1 du substrat 100. La région isolante 139 est en tout matériau diélectrique. Elle est ici en oxyde de silicium.

La zone de pincement 121 est dopée du deuxième type de conductivité, dopée p dans cet exemple. Elle comporte avantageusement une zone dopée périphérique 141 commune aux première et deuxième zones de stockage commandables, s'étendant horizontalement dans une région périphérique du pixel de profondeur 5. La zone de pincement 121 a une concentration P1 en éléments dopants. Elle peut s'étendre plus profondément dans le substrat 100 au niveau de sa zone dopée périphérique 141. Dans cet exemple, elle s'étend verticalement dans le substrat 100 sur une profondeur sensiblement constante, par exemple supérieure ou égale à une hauteur selon l'axe Z des régions isolantes 139. Les zones de pincement 121 avec leur zone dopée périphérique 141 commune peuvent par exemple être obtenues par une étape d'implantation localisée unique. Ici, la zone dopée périphérique 141 entoure la grille de transfert 111 de chaque zone de stockage commandable. Elle s'étend horizontalement sur sensiblement toute la surface du pixel de profondeur 5, en vue de dessus. Elle est en contact avec la grille de pincement 114 de chaque zone de stockage commandable. Ici, elle est en contact avec la grille de transfert inverse 112 de chaque zone de stockage commandable. Les zones de pincement 121 avec leur zone dopée périphérique 141 commune forment une zone dopée d'un seul tenant.

La grille de transfert 111 d'une zone de stockage commandable est agencée dans le pixel de profondeur 5 de sorte à écranter dans la barrière 131 correspondante, un champ électrique émis par la grille de transfert 111 de l'autre zone de stockage commandable, lorsque le capteur est en fonctionnement. Les grilles de transfert 111 respectives des première et deuxième zones de stockage commandables sont ici séparées d'une distance S mesurée parallèlement à l'axe X.

Pour un meilleur contrôle du canal de collecte 133, la distance S est de préférence choisie égale à une distance minimale autorisée par des règles de conception de la technologie utilisée pour réaliser le capteur. Les règles de conception prennent généralement en compte une distance minimale autorisée entre un contact électrique et une grille verticale, et une dimension minimale pour un contact électrique. A titre d'exemple, la distance S est comprise entre 10 nm et 300 nm, ici égale à 108 nm.

La grille de transfert 111 présente une forme en U en vue de dessus, entourant la voie d'écoulement. Elle comporte une portion principale formant la base du U, s'étendant parallèlement au plan (Y, Z), ainsi qu'une première branche et une deuxième branche du U s'étendant parallèlement au plan (X, Z). Dans cet exemple, la portion principale et la première branche ont des largeurs horizontales sensiblement égales à une valeur W. La deuxième branche a ici une largeur horizontale strictement supérieure à W. La largeur horizontale de la deuxième branche est par exemple suffisante pour garantir qu'un premier contact 161 du circuit de lecture repose entièrement sur la deuxième branche malgré des incertitudes de fabrication.

W peut être compris entre 20 nm et 300 nm. W est ici égal à 100 nm. La largeur de la deuxième branche est ici égale à 200 nm. Les première et deuxième branches ont des longueurs égales $W_N$, mesurées parallèlement à l'axe X. $W_N$ est par exemple compris entre 10 % et 40 % de la taille du pixel Px, ici égale à 326 nm. La première branche est séparée de la deuxième branche d'une distance $L_N$ mesurée parallèlement à l'axe Y, égale ici à 640 nm. La grille de transfert 111 peut s'étendre dans le substrat 100 sur une profondeur comprise entre 0,2 $\mu$m et 1,5 $\mu$m. La région isolante 139 peut avoir une hauteur mesurée parallèlement à l'axe Z inférieure à 600 nm, ici égale à 100 nm.

La grille de transfert 111 peut avoir d'autres formes en vue de dessus, comme par exemple une forme en L ou en I, avec ou sans empattements.

Dans cet exemple, la grille de transfert inverse 112 a une largeur horizontale sensiblement constante, par exemple comprise entre 20 nm et 300 nm, ici égale à 100 nm. La grille de pincement 114 est alignée sur la grille de transfert inverse 112. Elle a ici une largeur horizontale égale à celle de la grille de transfert inverse 112.

La zone de collecte 125 est dopée de type n. Elle comprend, comme représenté en figure 1B, une région dopée N 143 et un caisson N 142 optionnel. La région dopée N 143 s'étend horizontalement depuis la portion principale de la grille de transfert 111 d'une zone de stockage commandable jusqu'à la portion principale de la grille de transfert 111 de l'autre zone de stockage commandable. La zone de collecte 125 s'étend verticalement dans le substrat 100 depuis la face supérieure 100.1 sur une profondeur supérieure à la hauteur des régions isolante 139. La région dopée N 143 peut comprendre une région surdopée affleurant la face supérieure 100.1, formée à l'intérieur de la région dopée N 143, de sorte à réduire une résistivité de contact électrique entre la zone de collecte 125 et le circuit de lecture.

Le caisson N 142 s'étend horizontalement depuis la portion principale de la grille de transfert 111 d'une zone de stockage commandable jusqu'à la portion principale de la grille de transfert 111 de l'autre zone de stockage commandable. Il s'étend verticalement dans le substrat 100 plus profondément que la région dopée N 143. En vue de dessus, la région dopée N 143 occupe par exemple une surface du pixel située à l'intérieur du caisson N 142. Ici, le caisson N 142 s'étend selon l'axe Y, entre les portions principales des grilles de transfert 111 respectives des première et deuxième zones de stockage commandables, sur une longueur strictement inférieure à une longueur de vis-à-vis, le long de laquelle les grilles de transfert 111 sont en regard en vue de dessus. Ainsi, la zone de collecte 125 s'étend selon l'axe Y sur une longueur $L_C$ strictement inférieure à la longueur de vis-à-vis. Sur la figure 1A, elle est centrée sur le centre du pixel de profondeur 5.

Un profil de dopage vertical de la zone de collecte 125 est choisi pour augmenter une proportion de charges électriques transférées par le canal de collecte 133 lorsque les grilles de transfert 111 respectives des première et deuxième zones de stockage commandables sont activées simultanément. A titre d'exemple, dans ce mode de réalisation, le caisson N 142 s'étend verticalement dans le substrat 100 plus profondément que les régions mémoires 135 pour favoriser le transfert de charges électriques depuis la région photosensible 120 vers la zone de collecte 125, lors d'une phase d'initialisation de la région photosensible 120 et/ou entre des prises d'échantillons d'une phase d'échantillonnage T1 et/ou lors d'une phase d'attente de lecture d'échantillons, lorsque le capteur est en fonctionnement.

La longueur $L_C$ est par exemple supérieure ou égale à 100 nm. La longueur $L_N$ peut être comprise entre 15 % et 60 % de la taille du pixel Px, ici égale à 584 nm. La région dopée N 143 a une concentration en éléments dopants de type donneur comprise entre 1E16 at/cm$^3$ et 5E20 at/cm$^3$. Le caisson N 142 a une concentration en éléments dopants de type donneur comprise entre 1E16 at/cm$^3$ et 1E19 at/cm$^3$. Avantageusement, la concentration en éléments dopants de la région dopée N 143 est strictement supérieure à N2.

La région mémoire 135 s'étend en profondeur depuis la zone de pincement 121 jusqu'à la barrière 131. La grille de pincement 114 s'étend en profondeur dans le substrat 100 depuis la face supérieure 100.1. De préférence, elle s'étend jusqu'à sensiblement atteindre un plan de séparation entre la région mémoire 135 et la barrière 131, à des incertitudes de fabrication près.

Les électrodes 102 respectives de la grille de pincement 114 et de la grille de transfert inverse 112 sont isolées l'une de l'autre par le revêtement diélectrique 129. Elles sont par exemple séparées par le revêtement diélectrique 129 d'une distance comprise entre 2 nm et 100 nm, ici égale à 20 nm. Ici, les revêtements diélectriques 129 de toutes les électrode 102 de l'ensemble de grilles ont des épaisseurs sensiblement égales.

N1 est par exemple compris entre 1E10 at/cm$^3$ et 1E18 at/cm$^3$. N2 est par exemple compris entre 1E16 at/cm$^3$ et 1E19 at/cm$^3$. P1 est par exemple compris entre 1E17 at/cm$^3$ et 5E20 at/cm$^3$.

Le pixel de profondeur 5 comporte deux tranchées d'isolation périphérique 115 délimitant le pixel. Chaque tranchée d'isolation périphérique 115 s'étend verticalement dans une région périphérique du pixel, selon un plan parallèle au plan (X, Z). Elle s'étend verticalement dans le substrat 100, en regard de la région photosensible 120. Dans cet exemple, elle affleure la face supérieure 100.1. De préférence, Elle s'étend verticalement sur une profondeur sensiblement égale à l'épaisseur du substrat 100.

Dans cet exemple, les tranchées d'isolation périphérique 115 s'étendent le long de 2 faces opposées du pixel de profondeur 5. Chacune comporte une électrode verticale 106 revêtue d'un revêtement diélectrique 129. Le revêtement diélectrique 129 de la tranchée d'isolation périphérique 115 isole électriquement l'électrode verticale 106 du substrat 100. Ici, chaque tranchée d'isolation périphérique 115 comporte en outre une région isolante 139 recouvrant l'électrode verticale 106 et affleurant la face supérieure 100.1 du substrat 100. L'électrode verticale 106 est par exemple en silicium polycristallin dopé. Le revêtement diélectrique 129 est par exemple en oxyde de silicium. La région isolante 139 est par exemple en oxyde de silicium. Chaque électrode verticale 106 est connectée électriquement au circuit de lecture.

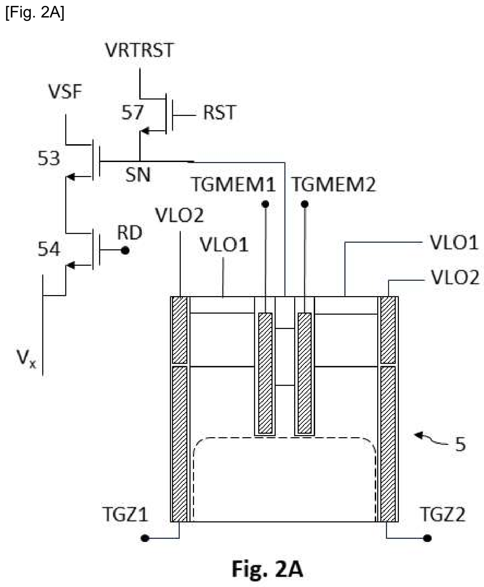

A présent, en lien avec la figure 2A, il va être décrit un circuit de lecture du capteur, adapté à l'exemple de pixel de profondeur 5 des figures 1A et 1B. Sur la figure 2A, on a repris la vue en coupe de la figure 1B sans les références. Des connexions électriques liant électriquement les différents éléments du pixel de profondeur 5 au circuit de lecture sont schématiquement représentées, mais ne sont pas nécessairement représentatives d'une disposition géométrique dans l'espace.

Le circuit de lecture comporte un premier contact 161, un deuxième contact 162, un quatrième contact 164, et un septième contact 167, par zone de stockage commandable. Le circuit de lecture comporte en outre un sixième contact 166, appelé aussi contact électrique d'initialisation 166.

Les grilles de pincement 114 sont chacune connectées électriquement via un quatrième contact 164 respectif, à un nœud ou un rail de fourniture d'un potentiel électrique VLO2. La grille de transfert inverse 112 de la première (respectivement deuxième) zone de stockage commandable est connectée électriquement via le deuxième contact 162, à un nœud ou un rail de fourniture d'un potentiel électrique TGZ1 (respectivement TGZ2). La grille de transfert 111 de la première (respectivement deuxième) zone de stockage commandable est connectée électriquement via le premier contact 161, à un nœud ou un rail de fourniture d'un potentiel électrique TGMEM1 (respectivement TGMEM2).

Chaque zone de pincement 121 est connectée électriquement à un nœud ou un rail de fourniture d'un potentiel électrique VLO1, via le septième contact 167. Alternativement, le circuit de lecture peut n'avoir qu'un septième contact 167 par pixel de profondeur 5, et la zone de pincement 121 dépourvue de contact électrique est connectée électriquement à l'autre zone de pincement 121 via la zone dopée périphérique 141.

Le circuit de lecture comporte en outre un transistor 53 monté en source suiveuse et un transistor de sélection 54. Les transistors 53 et 54 sont ici des transistors NMOS. Le drain du transistor 53 est connecté électriquement à un nœud ou un rail de fourniture d'un potentiel électrique VSF. La source du transistor 53 est connectée électriquement au drain du transistor de sélection 54. La source du transistor de sélection 54 est connectée électriquement à une ligne de sortie présentant un potentiel électrique Vx. La ligne de sortie est connectée à un pied de colonne de la matrice de pixels. La grille du transistor de sélection 54 est connectée électriquement à un nœud ou un rail de fourniture d'un potentiel électrique RD. La zone de collecte 125 est connectée électriquement à un nœud de lecture SN du circuit de lecture, via le sixième contact 166. Le nœud de lecture SN est connecté électriquement à la grille du transistor 53. Il est en outre connecté électriquement à un nœud ou un rail de fourniture d'un potentiel électrique VRTRST via le canal d'un transistor d'initialisation 57 du circuit de lecture. Le transistor d'initialisation 57 est commandé par un potentiel électrique RST. Il s'agit ici d'un transistor NMOS.

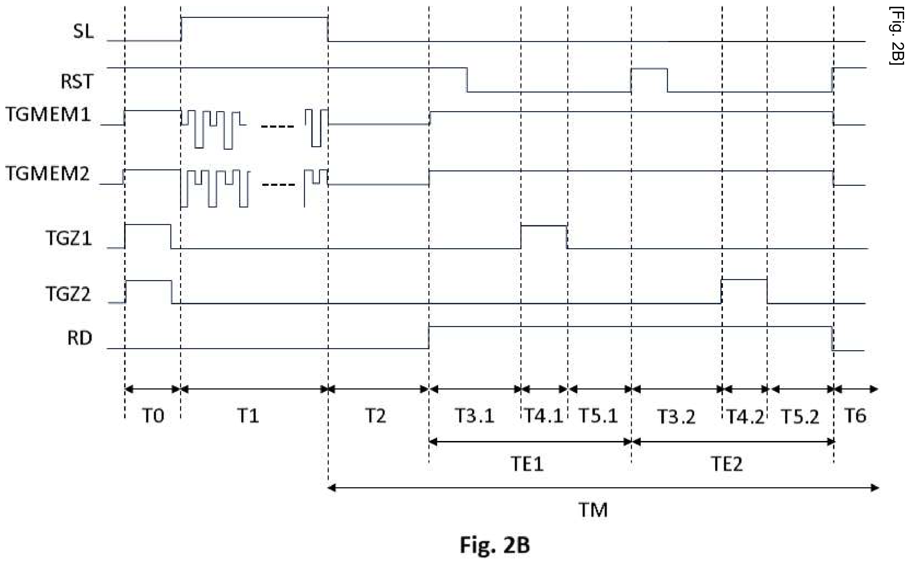

La figure 2B illustre un fonctionnement possible de ce circuit de lecture. Elle représente un chronogramme sur lequel on a reporté des potentiels électriques variant dans le temps. Certains parmi ceux-ci sont repérés par des disques pleins sur le schéma électrique de la figure 2A.

Lorsqu'une scène est éclairée par une source de lumière périodique en amplitude de période $P_S$, le chronogramme conduit à une intégration dans chaque zone de stockage commandable, d'une partie du signal lumineux réfléchi par la scène, sur des intervalles de temps périodiques de période égale à la période $P_S$ et de durée égale à $P_S/4$.

Le chronogramme est adapté à un capteur d'une image comprenant plusieurs pixels de profondeur 5 agencés en matrice. Il comporte successivement une phase d'initialisation T0, une phase d'échantillonnage T1 et une phase de lecture de la matrice TM. La phase de lecture de la matrice TM consiste en, successivement, une première phase d'attente T2 optionnelle, en une phase de lecture d'un premier échantillon TE1, une phase de lecture d'un deuxième échantillon TE2, et une deuxième phase d'attente T6 optionnelle. Le cumul des phases consécutives T0, T1 et TM constitue une phase d'acquisition d'une image en profondeur, ou d'acquisition d'une trame, par exemple si le capteur est apte à capturer plusieurs images successives. Le cas échéant, la phase de lecture de la matrice TM d'une trame peut être immédiatement suivie de la phase d'initialisation T0 de la trame suivante.

Afin de déterminer une information de profondeur à partir du signal lumineux périodique reçu par le capteur au cours d'une phase d'acquisition d'une image, le pixel de profondeur 5 peut appartenir à un macro-pixel Z comprenant plusieurs pixels de profondeur 5 identiques. Le cas échéant, les phases d'échantillonnage T1 de pixels de profondeur 5 distincts du macro-pixel Z sont décalés d'une fraction de période $P_S$, modulo la période $P_S$. Un macro-pixel Z peut par exemple consister en 2 pixels de profondeur 5 ayant leurs phases d'échantillonnage T1 décalées d'un quart de la période $P_S$, modulo la période $P_S$.

Alternativement, une information de profondeur peut être déterminée à partir du signal lumineux périodique reçu par le capteur au cours de phases d'acquisition de trames successives. A titre d'exemple, les phases d'échantillonnage T1 de deux trames successives peuvent être décalées d'un quart de la période $P_S$ modulo la période $P_S$, ou le signal lumineux est décalé d'un quart de la période $P_S$ modulo la période $P_S$ d'une trame à la suivante. L'information de profondeur est ensuite déterminée à partir des échantillons collectés par le pixel de profondeur 5 au cours des phases d'acquisition des deux trames successives. D'autres arrangements sont possibles encore, permettant d'acquérir une information de profondeur à partir d'échantillons collectés sur plusieurs trames avec un macro-pixel Z d'au moins un pixel de profondeur 5.

A titre d'exemple, il est possible de calculer un déphasage $\Delta\varphi$ entre les signaux lumineux émis et reçus permettant de déterminer une distance du capteur à la scène à partir de quatre échantillons C0, C1, C2 et C3, par application de la formule $\Delta\varphi = \arctan\left(\frac{C3-C1}{C0-C2}\right)$.
C0, C1, C2, C3 correspondent à des quantités de charges photo-générées au cours d'intervalles de temps égaux à $P_S/4$, se succédant immédiatement l'un après l'autre dans cet ordre, sans se superposer.

La phase de lecture d'un premier (respectivement deuxième) échantillon TE1 (respectivement TE2) consiste en, successivement, une phase de lecture T3.1 (respectivement T3.2) d'un potentiel électrique Vinit1 (respectivement Vinit2), une première (respectivement deuxième) phase d'évacuation de charges T4.1 (respectivement T4.2), et une phase de lecture T5.1 (respectivement T5.2) d'un potentiel électrique Vsig1 (respectivement Vsig2).

Au cours de la phase d'acquisition d'une image ou d'une trame, les potentiels électriques VLO1, VLO2, VSF et VRTRST sont fixes. A titre d'exemple, VLO1 est égal à - 0,5 V ou 0 V. VLO2 est par exemple égal à -0,8 V. VSF est par exemple égal à 1,8 V, 2,5 V ou 3,3 V. VRTRST est par exemple égal à 1,8 V, 2,5 V ou 3,3 V.

VL02 est strictement inférieur à VL01 de sorte que, dans chaque zone de stockage commandable, des trous issus de la zone de pincement 121 sont attirés le long de la grille de pincement 114 par un champ électrique entre la zone de pincement 121 et la grille de pincement 114 et forment ainsi une région d'inversion en contact avec la grille de pincement 114. La région d'inversion forme avec la région mémoire 135 une jonction latérale passivant la région mémoire 135.

Similairement, un contact électrique non représenté sur la figure 1A, connecte chaque électrode verticale 106 à un potentiel électrique fixe permettant de passiver des régions des pixels de profondeur 5 en regard des tranchées d'isolation périphérique 115.

Le transistor d'initialisation 57 est maintenu passant (RST à une valeur haute) au cours des phases d'initialisation et d'échantillonnage T0, T1, ainsi qu'au cours des première et deuxième phases d'attente T2, T6.

Au cours de la phase d'initialisation T0, la région photosensible 120 et la région mémoire 135 sont vidées d'éventuelles charges électriques qu'elles pourraient contenir. Pour cela, les potentiels électriques TGMEM1, TGMEM2, TGZ1 et TGZ2 sont tout d'abord, tous les quatre, égaux à une valeur haute $V_H$. Le pixel de profondeur 5 est dans un état de polarisation pour lequel, depuis chaque zone de stockage commandable, le potentiel électrique augmente le long d'un chemin orienté reliant successivement la région mémoire 135, la barrière 131, la région photosensible 120, le canal de collecte 133 et la zone de collecte 125. Des électrons contenus dans la région mémoire 135 de chaque zone de stockage commandable s'écoulent ainsi, sous l'action d'un champ électrique le long du chemin, depuis la région mémoire 135 vers la zone de collecte 125.

Une fois que la région mémoire 135 est vide de charges électriques, c'est-à-dire initialisée, TGZ1 et TGZ2 sont basculés à une valeur basse $V_L$, TGMEM1 et TGMEM2 étant par ailleurs maintenus à la valeur haute $V_H$. La valeur basse $V_L$ est dans cet exemple égale à -0,8 V. La valeur $V_H$ est égale à 2,5 V. La différence de potentiel électrique entre la région photosensible 120 et la région mémoire 135 de chaque zone de stockage commandable change de signe. Le transfert de charges électriques depuis la région photosensible 120 vers la zone de collecte 125 est prioritaire. Il est maintenu prioritaire pendant un délai ajustable permettant de caler le début de la phase d'échantillonnage T1, par exemple, par rapport à la phase d'échantillonnage T1 d'un autre pixel de profondeur 5 coopérant pour obtenir une information de profondeur. Ainsi, la région photosensible 120 est dépourvue de charges électriques au début de la phase d'échantillonnage T1, c'est-à-dire qu'elle est initialisée.

Une configuration du pixel de profondeur 5, incluant la distance S et un profil de dopage de la voie d'écoulement additionnelle, est telle que la valeur haute $V_H$ est suffisante pour créer un champ électrique faisant converger prioritairement les charges électriques de la région photosensible 120 vers le canal de collecte 133. Ainsi, d'éventuels électrons présents dans la région photosensible 120, certains pouvant provenir de la région mémoire 135, transitent depuis la région photosensible 120 vers la zone de collecte 125. Le gradient de potentiel électrique est maximal en valeur absolue dans la direction de la zone de collecte 125. Dans cette configuration, le potentiel électrique diminue de part et d'autre du centre du pixel de profondeur 5, le long d'un axe parallèle à X au niveau des faces inférieures des grilles de transfert 111. Par conséquent, une différence de potentiel électrique $\delta V$ existe le long de cet axe, entre une face de chaque grille de transfert 111 en regard de la région mémoire 135 correspondante et une face opposée de la même grille de transfert 111 en regard du canal de collecte 133. A titre d'exemple, une différence de potentiel électrique $\delta V$ supérieure ou égale à 110 mV en valeur absolue est suffisante pour qu'au moins 97 % des charges transférées depuis la région photosensible 120 atteignent la zone de collecte 125. La proportion de charges transférées et $\delta V$ augmentent lorsque $V_H$ augmente et/ou S diminue et/ou la profondeur de la zone de collecte 125 augmente.

Au cours de la phase d'échantillonnage T1, on applique un train d'impulsions périodique à la grille de transfert 111 de chaque zone de stockage commandable. TGMEM1 et TGMEM2 sont chacune une fonction créneau périodique de période $P_S$, prenant les valeurs $V_L$, $V_H$ et $V_i$. $V_i$ est strictement supérieur à $V_L$ et inférieur ou égal à $V_H$. Ici, chaque créneau a durée égale à $P_S/4$. A chaque période de la fonction créneau, TGMEM1 bascule successivement de $V_i$, à $V_H$, puis à $V_L$ et enfin à $V_H$. TGMEM2 bascule simultanément et en opposition de phase par rapport à TGMEM1. TGZ1 et TGZ2 sont maintenus à la valeur basse $V_L$ pendant toute la phase d'échantillonnage T1. Le potentiel électrique de la région photosensible 120 est par conséquent strictement inférieur au potentiel électrique de la région mémoire 135 de chaque zone de stockage commandable.

La valeur $V_i$ est suffisante pour abaisser la barrière de potentiel entre la région photosensible 120 et la région mémoire 135, permettant ainsi de collecter des charges photo-générées dans la région mémoire 135. En outre, la configuration du pixel de profondeur 5, incluant la distance S et un profil de dopage de la voie d'écoulement additionnelle, rend le transfert de charges électriques depuis la région photosensible 120 vers la zone de collecte 125 prioritaire lorsque les grilles de transfert 111 des première et deuxième zones de stockage commandables sont toutes les deux polarisées à un potentiel électrique supérieur ou égal à $V_i$.

Au cours de la phase d'échantillonnage T1, on procède aux transferts des charges photo-générées dans la région photosensible 120, successivement vers la région mémoire 135 de la première zone de stockage commandable (TGMEM1 à $V_i$, TGMEM2 à $V_L$), la zone de collecte 125 (TGMEM1 à $V_H$, TGMEM2 à $V_H$), la région mémoire 135 de la deuxième zone de stockage commandable (TGMEM1 à $V_L$, TGMEM2 à $V_i$), et enfin vers la zone de collecte 125 (TGMEM1 à $V_H$, TGMEM2 à $V_H$). A l'issue de la phase d'échantillonnage T1, la région mémoire 135 de chaque zone de stockage commandable contient une quantité de charges électriques photo-générées correspondant à un échantillon.

Tout au long de la phase d'échantillonnage T1, le signal lumineux est actif (référence SL sur le chronogramme). De préférence, le signal lumineux SL n'est actif qu'au moment de la phase d'échantillonnage T1. Des moyens, comme une horloge ou un signal de synchronisation, permettent de synchroniser le signal lumineux avec le circuit de lecture. Ces moyens peuvent être externes ou intégrés au capteur, en totalité ou en partie. Alternativement, le capteur peut comporter des moyens pour obturer le signal lumineux réfléchi par la scène avant d'atteindre la région photosensible 120, en dehors de la phase d'échantillonnage T1.

La première phase d'attente T2 suit la phase d'échantillonnage T1. Il s'agit d'une phase d'attente de sélection de la ligne ou de la colonne de la matrice à laquelle le pixel de profondeur 5 appartient. Cette phase est généralement mise à profit pour lire d'autres lignes ou colonnes. Au cours de cette phase, TGZ1 et TGZ2 sont égaux à $V_L$, tandis que TGMEM1 et TGMEM2 sont égaux à $V_i$. Cette situation permet un transfert prioritaire des charges électriques depuis la région photosensible 120 vers la zone de collecte 125. Elle permet d'éviter que d'éventuelles charges électriques additionnelles générées dans la région photosensible 120 après la phase d'échantillonnage T1, ne soient transférées à une région mémoire 135 entre la phase d'échantillonnage T1 et la lecture de la valeur de l'échantillon collecté dans la région mémoire 135 au cours de la phase d'échantillonnage T1. Cette fonction est parfois appelée anti-éblouissement (ou « anti-blooming, en anglais).

La première phase d'attente T2 est suivie de la phase de lecture d'un premier échantillon TE1 collecté par la première zone de stockage commandable. Elle débute par une phase optionnelle de lecture T3.1 d'un potentiel électrique Vinit1. La phase de lecture T3.1 commence lorsque le transistor de sélection 54 est mis à un état passant (RD à une valeur haute). TGMEM1 et TGMEM2 peuvent être maintenus à $V_i$. De préférence, TGMEM1 et TGMEM2 sont maintenu égaux à un même potentiel électrique supérieur ou égal à Vi, constant au cours des phases de lecture des premier et deuxième échantillons TE1, TE2. Ici, TGMEM1 et TGMEM2 sont basculés à $V_H$, simultanément au passage à l'état passant du transistor de sélection 54.

Le transistor d'initialisation 57 est maintenu passant (RST à une valeur haute) avant d'être basculé à un état bloqué (RST à une valeur basse), pendant une durée permettant une première initialisation du nœud de lecture SN. Au moment du basculement de RST, le signal lumineux est déjà interrompu ou obturé de sorte qu'aucune charge électrique n'est photo-générée par le signal lumineux. Le nœud de lecture SN est ainsi initialisé à un potentiel électrique Vinit1, sensiblement constant jusqu'à la fin de la phase de lecture T3.1, correspondant à VRTRST additionné d'un potentiel électrique $V_{kTC}$ correspondant à un bruit thermique du circuit de lecture. La valeur du potentiel électrique Vinit1 est lue sur la ligne de sortie et stockée en pied de colonne. Le nœud de lecture SN présente une capacité $C_{SN}$. La capacité $C_{SN}$ n'est pas forcément un composant indépendant du circuit de lecture. Elle peut être induite par différents facteurs liés au design et aux matériaux, comme par exemple des lignes d'interconnexions, une ou des grilles de transistor...

Une première phase d'évacuation de charges T4.1 fait suite à la phase de lecture T3.1. Elle commence lorsque TGZ1 bascule à la valeur haute $V_H$. TGZ2, TGMEM1 et TGMEM2 sont respectivement maintenus à $V_L$, $V_H$ et $V_H$ pendant toute la première phase d'évacuation de charges T4.1. Le pixel de profondeur 5 est dans un état de polarisation pour lequel le potentiel électrique croît le long d'un premier passage, depuis la région mémoire 135 de la première zone de stockage commandable jusqu'à la zone de collecte 125, en passant par la région photosensible 120. Les électrons contenus dans la région mémoire 135 de la première zone de stockage commandable s'écoulent ainsi sous l'effet d'un champ électrique, depuis la région mémoire 135 vers la zone de collecte 125. Alternativement, l'écoulement des électrons sous l'effet du champ électrique, depuis la région mémoire 135 jusqu'à la zone de collecte 125, se fait en deux étapes : une première **étape au cours** de laquelle les électrons s'écoulent jusqu'à la région photosensible 120 lorsque TGZ1 est à la valeur haute $V_H$, et une deuxième étape au cours de laquelle les électrons s'écoulent depuis la région photosensible 120 vers la zone de collecte 125 lorsque TGZ1 bascule à la valeur basse $V_L$.

A l'issue de la première phase d'évacuation de charges T4.1, la région mémoire 135 de la première zone de stockage commandable est vidée des charges électriques qui avaient été transférées depuis la région photosensible 120 au cours de la phase d'échantillonnage T1. Elle retourne à son potentiel de pincement. Les charges photo-générées atteignent la zone de collecte 125 et chargent la capacité $C_{SN}$ du nœud de lecture SN à un potentiel électrique Vsig1.

La première phase d'évacuation de charges T4.1 est suivie d'une phase de lecture T5.1 du potentiel électrique Vsig1. La phase de lecture T5.1 commence après avoir basculé TGZ1 à la valeur basse $V_L$, TGMEM1 et TGMEM2 étant maintenus à $V_H$. La valeur du potentiel électrique Vsig1 est lue sur la ligne de sortie et stockée en pied de colonne. Vsig1 est représentatif du nombre de charges électriques photo-générées et collectées dans la région mémoire 135 au cours de la phase d'échantillonnage T1.

La phase de lecture T5.1 est suivie de la phase de lecture d'un deuxième échantillon TE2 collecté par la deuxième zone de stockage commandable. Elle débute par une phase optionnelle de lecture T3.2 d'un potentiel électrique Vinit2. La phase de lecture T3.2 commence lorsque le transistor d'initialisation 57 passe à un état passant (RST à une valeur haute). TGMEM1, TGMEM2, TGZ1 et TGZ2 sont maintenus à leurs potentiels électriques respectifs. La phase de lecture T3.2 est similaire à la phase de lecture T3.1. Le transistor d'initialisation 57 est maintenu passant avant d'être basculé à un état bloqué (RST à une valeur basse), pendant une durée permettant une deuxième initialisation du nœud de lecture SN. Le nœud de lecture SN est initialisé à un potentiel électrique Vinit2 correspondant à VRTRST additionné d'un potentiel électrique correspondant à l'état du bruit kTC sur le nœud de lecture SN au moment de la fermeture du canal du transistor d'initialisation 57.

La phase de lecture T3.2 est suivie d'une deuxième phase d'évacuation de charges T4.2. La séquence du chronogramme au cours de la deuxième phase d'évacuation de charges T4.2 est similaire ou identique à celle de la première phase d'évacuation de charges T4.1, en inversant TGZ2 et TGZ1. Les électrons contenus dans la région mémoire 135 de la deuxième zone de stockage commandable s'écoulent sous l'effet d'un champ électrique, depuis la région mémoire 135 vers la zone de collecte 125. La région mémoire 135 retourne à son potentiel de pincement. Les charges photo-générées et stockées dans la deuxième zone de stockage commandable atteignent la zone de collecte 125 et chargent la capacité $C_{SN}$ du nœud de lecture SN à un potentiel électrique Vsig2.

La deuxième phase d'évacuation de charges T4.2 est suivie de la phase de lecture T5.2 du potentiel électrique Vsig2. La séquence du chronogramme au cours de la phase de lecture T5.2 est similaire ou identique à celle de la phase de lecture T5.1. La phase de lecture T5.2 se termine lorsque le transistor de sélection 54 est basculé à un état bloquant (RD à une valeur basse). La valeur du potentiel électrique Vsig2 est lue sur la ligne de sortie et stockée en pied de colonne. Vsig2 est représentatif du nombre de charges électriques photo-générées et collectées dans la région mémoire 135 de la deuxième zone de stockage commandable au cours de la phase d'échantillonnage T1.

Dans cet exemple, le capteur comporte des moyens pour opérer un double échantillonnage corrélé. Les moyens comprennent notamment les phases de lecture T3.1 et T3.2, le stockage des potentiels électriques Vinit1 et Vinit2 lus en pied de colonne et une cellule analogique produisant des signaux proportionnels respectivement à la différence de Vinit1 et Vsig1, et à la différence de Vinit2 et Vsig2. La cellule analogique soustrait par exemple Vsig1 à Vinit1 pour obtenir la valeur du premier échantillon, et Vsig2 à Vinit2 pour obtenir la valeur du deuxième échantillon. Les lectures de Vinit1 et Vsig1 étant consécutives, sans modification de l'état du transistor d'initialisation 57 entre les phases de lecture T3.1 et T5.1, la lecture de Vsig1 ne souffre d'aucun bruit thermique additionnel à celui déjà présent lors de la lecture de Vinit1. Ainsi, la soustraction de Vinit1 à Vsig1 permet de supprimer le bruit kTC. Les lectures de Vsig1 et Vinit1 sont dites corrélées. Similairement, les lectures de Vinit2 et Vsig2 sont consécutives, sans modification de l'état du transistor d'initialisation 57. Les lectures de Vsig2 et Vinit2 sont corrélées.

La phase de lecture du deuxième échantillon TE2 est suivie d'une deuxième phase d'attente T6 optionnelle au cours de laquelle d'autres lignes de la matrice de pixel sont éventuellement sélectionnées. Les potentiels électriques du chronogramme sont à des valeurs identiques à celles de la première phase d'attente T2. Après la deuxième phase d'attente T6, par exemple immédiatement après, les phases d'initialisation T0, d'échantillonnage T1 et de lecture de la matrice TM peuvent être répétées pour acquérir une autre trame.

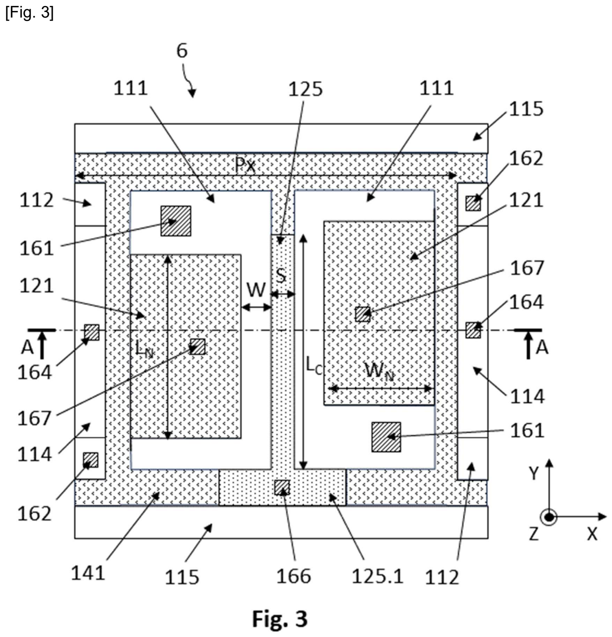

En figure 3, on a représenté une vue de dessus d'un pixel de profondeur 6, permettant de diminuer la distance S. Il s'agit d'une variante du pixel de profondeur 5 de la figure 1A pour laquelle la figure 1B est également une vue en coupe selon le plan de coupe A-A de la figure 3. Seules les différences de cette variante sont explicitement décrites.

En figure 3, le pixel comporte en outre une zone de contact périphérique 125.1 sur laquelle repose le contact électrique d'initialisation 166. La zone de contact périphérique 125.1 est en contact physique et électrique avec la zone de collecte 125. Elle est par exemple formée d'un seul tenant avec la zone de collecte 125. Elle est dopée du même type de conductivité que la zone de collecte 125, ici de type n. Elle s'étend en profondeur dans le substrat 100 depuis la face supérieure 100.1. Dans cet exemple, elle s'étend horizontalement depuis la zone de collecte 125 et depuis les grilles de transfert 111, jusqu'à atteindre une tranchée d'isolation périphérique 115. Elle a par exemple une hauteur le long de l'axe Z, inférieure ou égale à la hauteur de la zone de collecte 125, sans que cela soit indispensable.

La zone de contact périphérique 125.1 a des dimensions et une concentration en éléments dopants ajustés de façon à ne pas créer de barrière ou de puits de potentiel entre la zone de collecte 125 et le contact électrique d'initialisation 166 lorsque le capteur est en fonctionnement. Lorsque la zone de contact périphérique 125.1 et la zone de collecte 125 sont d'égales hauteurs, elles peuvent être réalisées par la même succession d'étapes de procédé. Elles présentent alors des profils de dopage le long de l'axe Z sensiblement identiques, comme cela est le cas ici.

En vue de dessus, le contact électrique d'initialisation 166 est déporté dans une région périphérique du pixel de profondeur 6 permettant de rapprocher les grilles de transfert 111 sans enfreindre une règle de conception de la technologie utilisée pour réaliser le capteur, tel qu'une règle d'espacement minimal entre un contact et une grille verticale. La distance S peut ainsi être réduite par rapport au pixel de profondeur 5 de la figure 1A. Elle est ici égale à 70 nm. Le rapprochement des grilles de transfert 111 permet d'augmenter la capacité de stockage des régions mémoire 135 et/ou de favoriser le transfert des charges photo-générées depuis la région photosensible 120 vers les régions mémoire 135 lors de la phase d'échantillonnage T1.

Dans cette variante, le contour de la zone dopée périphérique 141 épouse celui des tranchées d'isolation périphérique 115 en vue de dessus, à l'exception d'une région du pixel à l'intérieur de laquelle la contact périphérique 125.1 est en contact avec la tranchée d'isolation périphérique 115.

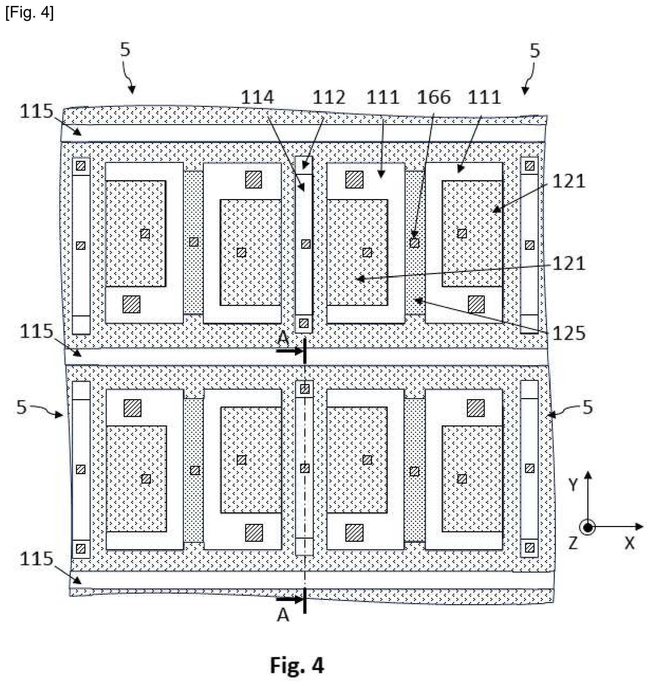

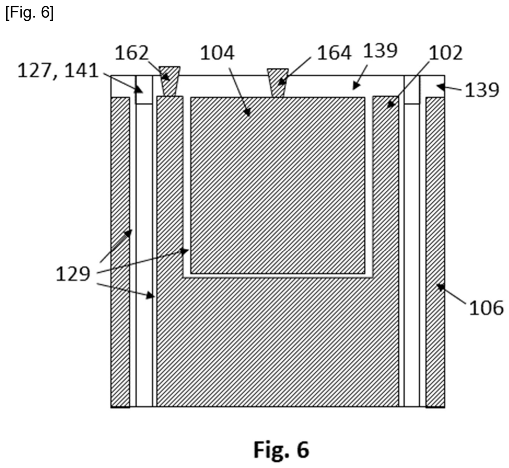

A présent, un capteur comportant une matrice de pixels de profondeur 5 va être décrit en lien avec la figure 4. Tous les pixels de profondeur 5 sont identiques. Chaque pixel de profondeur 5 est similaire ou identique à celui des figures 1A et 1B. La figure 6 est une vue schématique selon la coupe A-A de la figure 4.

Sur la figure 4, on a représenté une sous-matrice de la matrice consistant en deux lignes et deux colonnes. Les lignes de pixels de profondeur 5 s'étendent le long de l'axe X, les colonnes, le long de l'axe Y. Les grilles de transfert inverse 112 de deux zones de stockage commandables contigües appartenant à deux pixels de profondeur 5 d'une même ligne sont actionnées simultanément. Les délais ajustables des phases d'initialisation T0 de deux pixels de profondeur 5 peuvent être différents si ces derniers coopèrent pour obtenir une information de profondeur. Il est par exemple possible de faire coopérer deux pixels de profondeur 5 d'une même ligne ou d'une même colonne, pour obtenir une information de distance. Un chronogramme similaire à celui de la figure 2B peut être appliqué à chaque pixel de profondeur 5. Les pixels de profondeur 5 peuvent être lus ligne à ligne ou colonne à colonne.

Chaque grille de transfert inverse 112 et chaque grille de pincement 114 sont communes à deux pixels de profondeur 5 contigus de la matrice. Ces derniers sont par exemple symétriques l'un de l'autre par rapport au plan vertical selon lequel la grille de transfert inverse 112 et la grille de pincement 114 s'étendent, comme cela est représenté ici.

Chaque tranchée d'isolation périphérique 115 est commune à deux pixels de profondeur 5 contigus. Ainsi, les tranchées d'isolation périphérique 115 de la matrice forment, en vue de dessus, un ensemble de lignes d'un seul tenant séparant deux lignes de pixels de profondeur 5 de la matrice. Les électrodes verticales 106 forment des parois verticales d'un seul tenant séparant deux lignes contigües de pixel de profondeur 5. Chaque ligne d'électrodes verticales 106 est ici connectée au potentiel fixe par un contact électrique agencé en périphérie de la matrice.

Les zones dopées périphériques 141 de deux pixels de profondeur 5 contigus d'une même ligne se rejoignent au niveau du plan de la grille de transfert inverse 112 commune, pour former une zone d'un seul tenant. Chaque pixel de profondeur 5 peut être un pixel de profondeur 6 selon la figure 3, présentant une zone de contact périphérique 125.1 prolongeant la zone de collecte 125 dans une région périphérique du pixel sur laquelle repose le contact électrique d'initialisation 166.

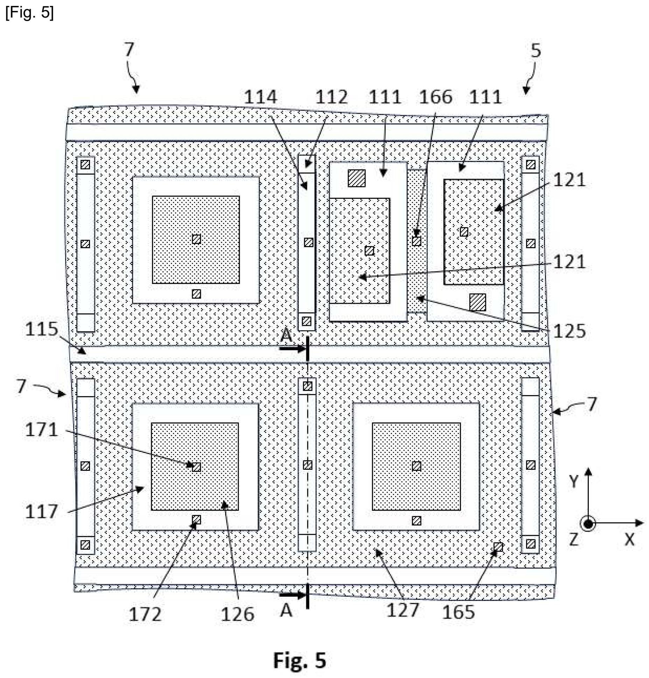

A présent, il va être décrit un capteur comportant une matrice de pixels mixant des pixels d'intensité 7 et des pixels de profondeur 5. Plusieurs pixels d'intensité 7 peuvent être insérés dans la matrice de pixels. Sur la figure 5, on a représenté un ensemble de 4 pixels de la matrice en vue de dessus. La figure 6 est également une vue selon la coupe A-A de la figure 5. L'ensemble de 4 pixels est par exemple répété périodiquement pour former la matrice. Il comporte ici 3 pixels d'intensité 7 et un pixel de profondeur 5. Seules les différences avec le capteur de la figure 4 sont explicitement décrites. Les pixels de profondeur et d'intensité 5, 7 ont des empreintes horizontales superposables, c'est-à-dire que toutes leurs dimensions horizontales sont égales.

Le pixel de profondeur 5 est identique à celui décrit en lien avec la figure 4. Chaque pixel d'intensité 7 peut être tout type de pixel délivrant un signal proportionnel à l'intensité d'une partie du rayonnement électromagnétique issu de la scène et incident sur la face inférieure du substrat 100, ne comprenant pas le signal lumineux. Le pixel d'intensité 7 peut par exemple être un pixel similaire ou identique à celui décrit dans le document US 2019/0237499 A1.

Chaque pixel d'intensité 7 comporte une grille de transfert 117, une zone de détection 126 et un caisson 127. Il comporte en outre des tranchées d'isolation périphérique 115 identiques au pixel de profondeur 5. La matrice de pixels de la figure 5 est obtenue en remplaçant des pixels de profondeur 5 de la matrice de la figure 4 par des pixels d'intensité 7. Ainsi, les tranchées d'isolation périphérique 115 forment, en vue de dessus, un ensemble de lignes d'un seul tenant séparant deux lignes de pixels de la matrice.

La zone de détection 126 et le caisson 127 sont dopés de types de conductivité opposés. Dans cet exemple, sans que cela soit essentiel, le caisson 127 est dopé du même type de conductivité que la zone de pincement 121 et sa zone dopée périphérique 141. Le caisson 127 et la zone de pincement 121 peuvent par exemple résulter d'une ou plusieurs étapes d'implantation communes.

Sur la figure 5, une première ligne de la matrice délimitée par les tranchées d'isolation périphérique 115 comprend deux pixels d'intensité 7. Une deuxième ligne comprend un pixel de profondeur 5 et un pixel d'intensité 7. Dans la première ligne, les caissons 127 se rejoignent pour former une zone dopée d'un seul tenant. Similairement, dans la deuxième ligne, la zone de pincement 121 rejoint le caisson 127 pour former une autre zone dopée d'un seul tenant.

La grille de transfert 117 s'étend verticalement dans le substrat 100 depuis la face supérieure 100.1. Elle a une forme sensiblement carrée ou rectangulaire en vue de dessus. Elle entoure de toute part la zone de détection 126. La zone de détection 126 s'étend d'un bord à l'autre de la grille de transfert 117. Le caisson 127 s'étend d'une tranchée d'isolation périphérique 115 à une autre. Il entoure la grille de transfert 117.

Des charges électriques photo-générées dans une région photosensible du pixel d'intensité 7 sont collectées dans la zone de détection 126 lorsque la grille de transfert 117 est activée. La grille de transfert 117 est située à l'aplomb de cette région photosensible.

Le pixel de profondeur 5 ne partage pas ses grilles de transfert inverse 112 et ses grilles de pincement 114 avec un pixel de profondeur 5 voisin. Avantageusement, chaque pixel d'intensité 7 est séparé d'un pixel voisin par une grille de transfert inverse 112 et une grille de pincement 114 identiques à celles du pixel de profondeur 5, et agencées de la même façon. Ainsi, tous les pixels d'intensité 7 présentent des caractéristiques de fonctionnement identiques. Les grilles de transfert inverse et de pincement 112, 114 de la première ligne sont avantageusement polarisées par des contacts électriques, lorsque le capteur est en fonctionnement.

Pour chaque pixel d'intensité 7, la zone de détection 126 et la grille de transfert 117 sont connectés à un circuit de contrôle par, respectivement, un contact de lecture 171 et un contact de grille 172 du circuit de contrôle. Le circuit de contrôle peut être une partie du circuit de lecture ou un circuit indépendant. Les caissons 127 des pixels d'intensité 7 de la première ligne sont connectés au circuit de contrôle par un cinquième contact 165. En fonctionnement, le caisson 127 du pixel d'intensité 7 de la deuxième ligne est ici polarisé via le septième contact 167 et la zone de pincement 121 du pixel de profondeur 5.

A titre d'exemple, le capteur peut être configuré pour capturer une image couleur. Les pixels d'intensité 7 de l'ensemble de 4 pixels peuvent alors chacun être sensible dans une gamme de longueurs d'onde du spectre visible distincte des deux autres pixels d'intensité 7 de l'ensemble. Il est possible de les associer à un filtre pixellisé disposé en regard de la face inférieur substrat 100 de sorte que chaque pixel soit exclusivement sensible à l'une des trois couleurs parmi le rouge, le vert ou le bleu.

Des modes de réalisation particuliers viennent d'être décrits. Différentes variantes et modifications apparaîtront à la personne du métier. L'agencement particulier des grilles de transfert et de transfert inverse, entre-elles et par rapport à la voie d'écoulement, est notamment un élément essentiel au transfert bidirectionnel entre la région photosensible et la région mémoire permettant d'atteindre l'objectif de compacité de l'invention. Celui-ci est exploitable dans des pixels de profondeur similaires, connectés à d'autres circuits de lecture, par exemple un circuit de lecture effectuant une lecture des potentiels électriques Vsig1 ou Vsig2 sur un nœud de lecture couplé à la région mémoire correspondante par un couplage capacitif faisant intervenir la grille de transfert ou de la grille de pincement.

Enfin, il est à la portée de la personne du métier de réaliser un pixel de profondeur comportant plus de deux zones de stockage commandables à partir de l'enseignement technique délivré supra. Un pixel de profondeur peut par exemple comprendre 4 zones de stockage commandables disposées aux quatre coins du pixel. Les grilles de transfert 111 peuvent alors avoir des formes en L en vue de dessus, dont les faces sont alignées sur des plans parallèles au plan (X, Z) ou (Y, Z). La voie d'écoulement additionnelle s'étend verticalement à l'aplomb de la région photosensible, en vis-à-vis des quatre grilles de transfert, dans une région centrale du pixel. Elle peut par exemple avoir une forme en croix orthogonale en vue de dessus, s'étendant horizontalement d'une grille de transfert à une autre. La grille de transfert inverse de chaque zone de stockage commandable peut également avoir une forme en L, s'étendant verticalement en vis-à-vis de la voie d'écoulement correspondante et délimitant un angle du pixel.

## Revendications

1. Capteur d'une image comprenant un circuit de lecture et une pluralité de pixels formés dans et/ou sur un substrat (100) du capteur, tel qu'au moins un parmi les pixels est un pixel de profondeur (5, 6), chaque pixel de profondeur comportant :

   • une région photosensible (120) du substrat (100),
   • une première et une deuxième zones de stockage commandables, chaque zone de stockage commandable comprenant :

      ▪ une voie d'écoulement de charges électriques s'étendant verticalement dans le substrat (100) à l'aplomb de la région photosensible (120) et comportant un puits de potentiel nommé région mémoire (135) et une barrière de potentiel électrique nommée barrière (131) intercalée entre la région mémoire (135) et la région photosensible (120),
      ▪ une grille de transfert (111) s'étendant verticalement dans le substrat (100) à l'aplomb de la région photosensible (120), en vis-à-vis de la barrière (131),
      ▪ une grille de transfert inverse (112) s'étendant verticalement dans le substrat (100) en vis-à-vis de la barrière (131) et d'une partie supérieure de la région photosensible (120),

      ▪ une voie additionnelle d'écoulement de charges électriques s'étendant verticalement dans le substrat (100) entre les grilles de transfert (111) respectives des première et deuxième zones de stockage commandables, à l'aplomb de la région photosensible (120), comportant un puits de potentiel électrique nommé zone de collecte (125) et une barrière de potentiel électrique, nommée canal de collecte (133), intercalée entre la zone de collecte (125) et la région photosensible (120),

   le circuit de lecture comportant un nœud de lecture (SN) connecté électriquement à la zone de collecte (125) et étant configuré pour successivement :

      • appliquer, dans chaque zone de stockage commandable, un train d'impulsions périodique à la grille de transfert (111) au cours d'une phase d'échantillonnage (T1) commune à la première et à la deuxième zones de stockage commandables, de sorte à écouler des charges électriques depuis la région photosensible (120) vers la région mémoire (135) au cours des impulsions, les trains d'impulsions respectifs des première et deuxième zones de stockage commandables étant déphasés l'un par rapport à l'autre, et de même période,
      • procéder à une première initialisation du nœud de lecture (SN),
      • procéder à une première évacuation de charges au cours de laquelle les grilles de transfert (111) des première et deuxième zones de stockage commandables, et la grille de transfert inverse (112) de la première zone de stockage commandable sont activées de sorte à écouler les charges électriques depuis la région mémoire (135) de la première zone de stockage commandables vers la zone de collecte (125),
      • lire un potentiel électrique Vsig1 du nœud de lecture (SN),
      • procéder à une deuxième initialisation du nœud de lecture (SN),
      • procéder à une deuxième évacuation de charges au cours de laquelle les grilles de transfert (111) des première et deuxième zones de stockage commandables, et la grille de transfert inverse (112) de la deuxième zone de stockage commandable sont activées de sorte à écouler les charges électriques depuis la région mémoire (135) de la deuxième zone de stockage commandables vers la zone de collecte (125),
      • lire un potentiel électrique Vsig2 du nœud de lecture (SN).

2. Capteur selon la revendication 1, dans lequel le circuit de lecture est configuré pour lire un potentiel électrique Vinit1 du nœud de lecture (SN) entre la première initialisation et la première évacuation, et un potentiel électrique Vinit2 du nœud de lecture (SN) entre la deuxième initialisation et la deuxième évacuation ; le capteur étant tel qu'il comprend des moyens pour opérer un premier double échantillonnage corrélé à partir de Vinit1 et Vsig1, et un deuxième double échantillonnage corrélé à partir de Vinit2 et Vsig2.

3. Capteur selon la revendication 1 ou 2, dans lequel chaque zone de stockage commandable comporte une grille de pincement (114) ; dans lequel, dans chaque zone de stockage commandable, la voie d'écoulement comporte une zone de pincement (121) recouvrant la région mémoire (135) d'un côté de la région mémoire (135) opposé à la barrière (131), la grille de pincement (114) s'étend verticalement dans le substrat (100) en vis-à-vis de la région mémoire (135), et le circuit de lecture est configuré pour appliquer une différence de potentiel électrique entre la zone de pincement (121) et la grille de pincement (114) de sorte à passiver la région mémoire (135) à partir de charges électriques issues de la zone de pincement (121).

4. Capteur selon la revendication 3, dans lequel, dans chaque zone de stockage commandable, la grille de pincement (114) est logée dans une encoche pratiquée dans la grille de transfert inverse (112).

5. Capteur selon l'une quelconque des revendications 1 à 4, dans lequel la zone de collecte (125) s'étend verticalement dans le substrat (100), plus profondément que les régions mémoires (135) des première et deuxième zones de stockage commandables.

6. Capteur selon l'une quelconque des revendications précédentes, dans lequel, pour chaque pixel de profondeur (5, 6), le canal de collecte (133), la zone de collecte (125), la barrière (131) et la région mémoire (135) de chaque zone de stockage commandable sont dopés d'un premier type de conductivité, et chaque région mémoire (135) a une concentration en éléments dopants strictement inférieure à une concentration en éléments dopants de la zone de collecte (125).

7. Capteur selon les revendications 3 et 6, dans lequel, pour chaque pixel de profondeur (5, 6), chaque zone de pincement (121) est dopée d'un deuxième type de conductivité opposé au premier type de conductivité.

8. Capteur selon la revendication 6 ou 7, dans lequel le canal de collecte (133) et la barrière (131) de chaque zone de stockage commandable ont des concentrations en éléments dopants identiques.

9. Capteur selon l'une quelconque des revendications 6 à 8, dans lequel, pour chaque pixel de profondeur (5, 6), la grille de transfert (111) de chaque zone de stockage commandable a une forme en U en vue de dessus, entourant la voie d'écoulement.

10. Capteur selon l'une quelconque des revendications 6 à 9, dans lequel le circuit de lecture comporte un contact électrique d'initialisation (166) par pixel de profondeur (6), et dans lequel chaque pixel de profondeur (6) comporte une zone de contact périphérique (125.1) du premier type de conductivité d'un seul tenant avec la zone de collecte (125), agencée en périphérie du pixel de profondeur (6), sur laquelle repose le contact électrique d'initialisation (166).

11. Capteur selon la revendication 3, dans lequel, pour chaque pixel de profondeur (5, 6) et chaque zone de stockage commandable, la grille de pincement (114) occupe une encoche pratiquée dans la grille de transfert inverse (112).

12. Capteur selon la revendication 3, dans lequel la pluralité de pixels est agencée en matrice et dans lequel les grilles de pincement (114) et les grilles de transfert inverse (112) sont agencées dans des plans de séparation entre deux pixels de la matrice de pixels.

13. Capteur selon la revendication 12, dans lequel tous les pixels de la matrice ont la même taille, et dans lequel la matrice de pixels comporte des pixels d'intensité (7) configurés pour délivrer un signal représentatif d'une intensité d'un flux lumineux incident.

[Fig. 1A]

Fig. 1A

[Fig. 1B]

Fig. 1B

[Fig. 2A]

**Fig. 2A**

[Fig. 2B]

Fig. 2B

[Fig. 3]

Fig. 3

[Fig. 4]

Fig. 4

[Fig. 5]

**Fig. 5**

[Fig. 6]

**Fig. 6**

EP 4 760 338 A1

| | Europäisches Patentamt European Patent Office Office européen des brevets | **RAPPORT DE RECHERCHE EUROPEENNE** | Numéro de la demande<br>EP 25 22 2101 |
|---|---|---|---|

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2023/007200 A1 (LIM JUNGWOOK [KR]) 5 janvier 2023 (2023-01-05) * alinéas [0002], [0008], [0090]; figures 5A, 5B, 5D, 10 * ----- | 1-13 | INV.<br>G01S7/481<br>G01S17/894<br>H04N25/705<br>H04N25/771 |
| A | US 2018/197910 A1 (LEE GWI-DEOK RYAN [KR] ET AL) 12 juillet 2018 (2018-07-12) * alinéas [0049], [0052], [0147], [0148]; figures 3, 7B, 9A, 9B * ----- | 1-13 | |
| A | US 2021/025993 A1 (CHOI WOON IL [US] ET AL) 28 janvier 2021 (2021-01-28) * alinéa [0065]; figures 2A, 4A * ----- | 1-13 | |
| A | US 2022/373653 A1 (NAKAMURA NOBUO [JP] ET AL) 24 novembre 2022 (2022-11-24) * abrégé; figure 6 * ----- | 1-13 | |

| | DOMAINES TECHNIQUES RECHERCHES (IPC) |
|---|---|
| | G01S<br>H04N |

Le présent rapport a été établi pour toutes les revendications

| Lieu de la recherche | Date d'achèvement de la recherche | Examinateur |
|---|---|---|
| Munich | 13 avril 2026 | Kirscher, Jérôme |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
............................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 25 22 2101

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

13-04-2026

| Document brevet cité au rapport de recherche | Date de publication | Membre(s) de la famille de brevet(s) | | Date de publication |
|---|---|---|---|---|
| US 2023007200 A1 | 05-01-2023 | CN | 115567790 A | 03-01-2023 |
| | | KR | 20230005605 A | 10-01-2023 |
| | | US | 2023007200 A1 | 05-01-2023 |
| US 2018197910 A1 | 12-07-2018 | CN | 108288623 A | 17-07-2018 |
| | | KR | 20180081869 A | 18-07-2018 |
| | | US | 2018197910 A1 | 12-07-2018 |
| US 2021025993 A1 | 28-01-2021 | CN | 112289817 A | 29-01-2021 |
| | | US | 2021025993 A1 | 28-01-2021 |
| US 2022373653 A1 | 24-11-2022 | CN | 114731381 A | 08-07-2022 |
| | | EP | 4080569 A1 | 26-10-2022 |
| | | JP | 7613864 B2 | 15-01-2025 |
| | | JP | 2021097214 A | 24-06-2021 |
| | | KR | 20220113694 A | 16-08-2022 |
| | | TW | 202137538 A | 01-10-2021 |
| | | US | 2022373653 A1 | 24-11-2022 |
| | | WO | 2021125116 A1 | 24-06-2021 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20190086519 A

- US 20190237499 A1